# EUROPÄISCHE PATENTSCHRIFT

(11) **EP 0 541 573 B1**
(45) Veröffentlichungstag und Bekanntmachung des Hinweises auf die Patenterteilung: **07.09.1994**
(21) Anmeldenummer: 91912315.8
(22) Anmeldetag: 10.07.1991
(51) Int. Cl.: G01D 18/00, G01D 3/02

(54) **MESSWERTAUFNEHMER**
MEASUREMENT VALUE SENSOR
CAPTEUR DE VALEURS DE MESURE

(30) Priorität: 01.08.1990 DE 4024402
(43) Veröffentlichungstag der Anmeldung: 19.05.1993
(73) Patentinhaber: Dr.Ing.h.c. F. Porsche Aktiengesellschaft, 70435 Stuttgart (DE)
(72) Erfinder: BAUMANN, Bernd, D-7251 Weissach (DE)
(86) Internationale Anmeldenummer: EP9101288
(87) Internationale Veröffentlichungsnummer: WO9202783

(56) Entgegenhaltungen:
- EP-A- 0 324 067
- EP-A- 0 406 627
- GB-A- 2 218 213
- US-A- 4 081 744

## Beschreibung

Die Erfindung betrifft einen Meßwertaufnehmer nach dem Anspruch 1.

Bei Meßgeräten oder Meßdatenerfassungs- und -verarbeitungssystemen ist es häufig erforderlich, den Meßwertaufnehmer mit dem eigentlichen physikalisch - elektrischen Wandler, der eine zu erfassende physikalische Größe erfaßt und in ein dazu äquivalentes elektrisches Signal umsetzt, von einer Auswerteschaltung zur Signal-(bzw. Meßwert-)aufbereitung und -verarbeitung räumlich abzusetzen. Meßwertaufnehmer und Auswerteschaltung sind dann in der Regel über elektrische Leitungen miteinander verbunden, wobei die Leitungen selbst über eine Steckverbindung an die Auswerteschaltung angeschlossen sind.

Die Auftrennung von Meßwertaufnehmer und Auswerteschaltung hat häufig räumliche Gründe (um den Meßwertaufnehmer möglichst klein bauen zu können), sie liegt aber auch oft in der "rauhen" Umgebung begründet, in der das Meßgerät betrieben werden soll. Dies sind häufig extrem hohe oder niedrige Temperaturen, Schmutz, Feuchtigkeit, hohe elektromagnetische Strahlung, usw., Bedingungen, unter denen zwar die Meßwertaufnehmer mehr oder weniger perfekt arbeiten können, die Funktionstüchtigkeit einer Auswerteschaltung mit empfindlichen elektronischen Bauteilen jedoch nicht gegeben ist.

Aus der DE-34 46 248 A1 ist ein Meßwertaufnehmer mit einem physikalisch - elektrischen Wandler bekannt, der baulich nicht mit einer Auswerteschaltung vereinigt ist. Der Aufnehmer umfaßt einen Speicherbaustein mit Korrekturdaten für die vom physikalisch - elektrischen Wandler erfaßten Meßwerte. Der physikalisch - elektrische Wandler und der Speicherbaustein sind über wenigstens einen Ausgang mit der Auswerteschaltung verbunden, die die Korrekturdaten aus dem Speicherbaustein auslesen und die vom Wandler gelieferten Meßwerte entsprechend korrigieren kann.

Dieser bekannte Meßwertaufnehmer und das Verfahren zu seinem Abgleich zeigen jedoch lediglich ein Prinzip für die Arbeitsweise eines derartigen Meßsystems auf, geben jedoch keinerlei Hinweis auf eine praktizierbare technische Ausführung. Ein Programmieren des Speicherbausteins mit den Korrekturwerten erfordert zudem ein Anschließen einer Vielzahl von Leitungen (Busanschluß), die nach Fertigstellung des Sensors von außen nicht mehr zugänglich sind, so daß ein "gealterter" Meßwertaufnehmer (d. h., ein Meßwertaufnehmer, der keine korrekten Daten mehr abliefert), nicht mehr rekalibriert werden kann; er muß daher ersetzt werden.

Ebenso geht aus der DE-33 18 977 A1 ein Meßwertaufnehmer mit einem Betriebsdaten enthaltenden Informationsträger (Speichermodul) hervor, bei dem Daten des Speichermoduls entweder über von den Meßleitungen getrennte, mehrere Anschlußleitungen bei Inbetriebnahme ausgelesen und an einen entfernt angeordneten Mikrorechner übertragen werden oder aber das gesamte Speichermodul entnommen und in einen entfernt vom Aufnehmer arbeitenden Verarbeitungsteil eingesetzt werden muß.

Es werden somit entweder mehrere zusätzliche Leitungen vom Aufnehmer zum Verarbeitungsteil notwendig oder ein manueller Arbeitsvorgang, der einerseits umständlich ist, andererseits jedoch häufig zu Beschädigungen der empfindlichen Anschlußkontaktstifte des Speicherbausteins führen kann.

Eine Einrichtung zum Messen physikalischer Größen mit einem Digitalspeicher ist mit der DE 31 16 690 A1 bekannt geworden. Dieser Digitalspeicher ist mit Eichdaten für die Einrichtung ladbar. Zum Ein-/Auslesen von Daten aus diesem Digitalspeicher sind jedoch spezielle elektrische Verbindungsleitungen vorzusehen, die die Einrichtung mit einem Auswertegerät zusätzlich zu den Meß- und Stromversorgungsleitungen verbinden.

Die DE- 37 43 846 A1 schließlich umfaßt einen Meßwertaufnehmer mit einem Speicherbaustein, welcher Bestandteil eines im Meßwertaufnehmer integrierten Kennungsgebers ist. Zur Initialisierung des Ausleseprozesses wird der Kennungsgeber über lediglich eine weitere Leitung mit einem Taktsignal beaufschlagt, das gleichzeitig der Taktsynchronisation und der Stromversorgung des Kennungsgebers dient. Die Daten werden beim Ausleseprozeß durch Ankoppelung des Kennungsgebers an die normalerweise der Meßwertübertragung dienenden Leitungen einer Auswerteschaltung mit analogen Eingängen zugeführt und dort aus den auf den Leitungen anstehenden Signalen oder deren Änderungen regeneriert. Dabei zieht bei Beaufschlagung des Kennungsgebers mit dem Taktsignal, d.h. mit Aufladen des Kondensators, das interne Bezugspotential auf das Bezugspotential herunter, bei nicht angesteuertem Kennungsgeber, d.h. bei geschaltetem Taktsignal wird der Feldeffekttransistor dagegen extrem hochohmig, so daß der Meßwiderstand und damit die Meßbrücke praktisch unbeeinflußt bleibt.

Weiter sind Meßwertaufnehmer mit physikalisch-elektrischen Wandlern bekannt, US-A 4,081,744, bei denen zu Kalibrierzwecken ein Shuntwiderstand über Shuntschalter parallel zu Brückenzweigen geschaltet werden kann (Shuntkalibrierung).

Schließlich ist eine Identifikationsvorrichtung für Meßgeber bekannt, EP-A-0 406 627, der durch eine Brückenschaltung gebildet wird, wobei der Meßgeber vor einer Meßreihe geprüft und kalibriert wird. Hierzu dient ein Kalibrierwiderstand, der mit Hilfe von zwei Schaltelementen an die Betriebsspannung angelegt oder fei geschaltet werden kann.

Es ist hierbei Aufgabe der Erfindung, in einen derartigen Meßwertaufnehmer mit Shuntkalibrierung einen Kennungsgeber derart zu integrieren, daß mit möglichst wenig Aufwand an zusätzlichen Bauteilen oder Leitungen ein gesteuertes Auslesen von Daten aus einem Speicher des Kennungsgebers und deren Übertragung zu einer Auswerteschaltung ermöglicht wird.

Die Erfindung ist durch die kennzeichnenden Merkmale des Anspruchs 1 gelöst. Weitere, die Erfindung in vorteilhafter Weise ausgestaltende Merkmale sind in den abhängigen Ansprüchen enthalten.

Die Vorteile der Erfindung sind in erster Linie darin zu sehen, daß ein Meßwertaufnehmer mit einem Korrekturdaten- Speicherbaustein geschaffen wurde, aus dem die Korrekturdaten bei Inbetriebnahme des Meßwertaufnehmers mit einfachen Mitteln gesteuert ausgelesen werden können, indem für diesen Ausleseprozeß weitgehend vorhandene, normalerweise der Meßwertübertragung oder der Energieversorgung bzw. einer Shuntkalibrierung des Aufnehmers dienende Leitungen verwendet werden.

Die hierfür im Meßwertaufnehmer anzuordnende Schaltung (Kennungsgeber) zeichnet sich durch eine geringe Anzahl von Schaltelementen aus und beeinflußt die Meßwerterfassung im Meßbetrieb in vernachlässigbarer Weise. Der Kennungsgeber zeichnet sich zudem durch einen hohen Betriebstemperaturbereich aus. Ferner können zusätzlich Daten bei einer Kalibrierung oder Rekalibrierung über die vorhandenen Leitungen von der Auswerteschaltung in den Speicherbaustein des Meßwertaufnehmers eingeschrieben werden.

Ein weiterer Vorteil ergibt sich bei diesem Kennungsgeber durch die Möglichkeit, Betriebsdaten des Meßwertaufnehmers wie z. B. Versorgungsspannung und Einsatzort im Speicherbaustein ablegen und auslesen zu können, da der Kennungsgeber völlig unabhängig vom eigentlichen Aufnehmer (physikalisch - elektrischer Wandler) betrieben werden kann.

Durch auf die Shuntleitung aufgeschalteten Zählimpulse und mittels einer diese zählende Schaltung im Kennungsgeber kann züdem der Kennungsgeber in seiner Betriebsart (Meßbetrieb, Kalibrierbetrieb, Identifizierbetrieb) umgeschaltet werden und die Initialisierung und Steuerung der Datenübertragung beeinflußt werden, so daß die Datenausgabe an unterschiedlichste Auswerteschaltungen anpaßbar ist oder eine Anfangsadresse für das Äuslesen der Daten aus dem Speicherbaustein verändert werden kann.

Die Erfindung wird anhand von in den Zeichnungen dargestellten Beispielen nachstehend näher erläutert.

Es zeigt
- Fig. 1: ein Blockschaltbild eines Meßwertaufnehmers mit Shuntkalibrierung, einem Kennungsgeber, sowie einer dazugehörigen Auswerteschaltung,
- Fig. 2: ein Blockschaltbild nach Fig. 1, jedoch mit einem weiter detailliert dargestellten Kennungsgeber,
- Fig. 3: ein Dreipegelsignal für die Übertragung von Steuerinformationen, Adressen und Daten auf einer Shuntleitung bzw. Meßleitung,
- Fig. 4: ein Schaltbild eines Kennungsgebers nach Fig. 2,
- Fig. 5: ein Schaltbild eines Teils einer steuernden Schaltung des Kennungsgebers,
- Fig. 6a-6e: Signal-Zeitdiagramme für einen Speicherbaustein des Kennungsgebers, für die Betätigung von Shuntschaltern und für Datensignale auf einer Shuntleitung und Meßsignalleitungen.

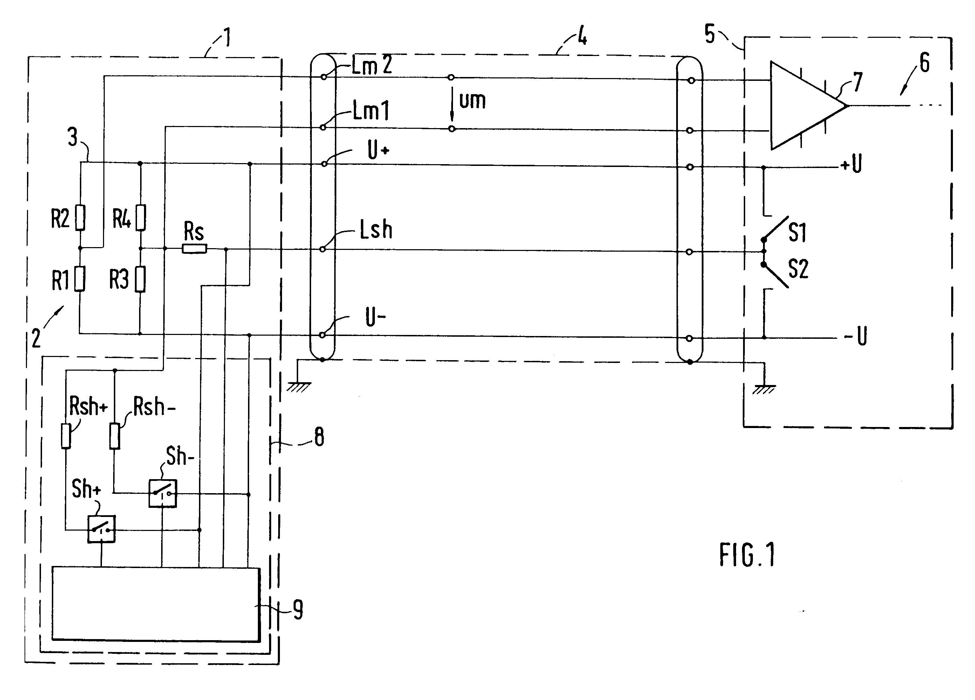

In Fig. 1 ist mit 1 ein Meßwertaufnehmer zur Erfassung einer physikalischen Größe gezeigt. Der Meßwertaufnehmer umfaßt einen physikalisch - elektrischen Wandler 2, beispielsweise einen zu einer Vollbrücke geschalteten Widerstandsmeßgeber 3 mit den (veränderlichen) Brückenwiderständen R1, R2, R3 und R4. Dies kann beispielsweise ein bekannter Dehnmeßstreifengeber zur Erfassung von Zugspannungen, Drücken (Membrandruckgeber), Kräften (Kraftmeßdose), Beschleunigungen (Beschleunigungsaufnehmer) usw. sein.
Der Widerstandsmeßgeber ist über ein Anschlußkabel mit Leitungen U+, U- zur Speisung einer ersten Brückendiagonale (Speisespannung +U, -U), d. h., zur Energieversorgung des Meßwertaufnehmers 1, und über Leitungen Lm1 und Lm2 zur Abnahme einer Meßspannung (um) von einer zweiten Brückendiagonalen mit einer Auswerteschaltung 5 verbunden, wie sie bspw. in der DE- 37 43 846 A1 beschrieben ist.

Die Auswerteschaltung 5 umfaßt neben einer Meßkette 6 mit einem Meßverstärker 7 und einer Spannungsversorgung +U, -U zusätzlich zwei Schalter (erster Shuntschalter S1, zweiter Shuntschalter S2), mit denen eine zum Meßwertaufnehmer 1 führende Shuntleitung Lsh gegen die Energieversorgungsleitungen U+, U- mit den Speisespannungen +U und -U gelegt werden kann. Diese Shuntschalter S1 und S2 können manuell zu betätigende Schalter sein, welche beim Abgleich des Meßwertaufnehmers 1 von einer Bedienperson gedrückt werden. Es ist jedoch auch denkbar, daß diese Shuntschalter S1, S2 elektronisch gesteuerte oder steuerbare Schalter sind, welche von der Auswerteschaltung 5 oder einem ihr nachgeschaltetem Rechnersystem selbsttätig angesteuert werden. Auf die Auswerteschaltung 5 soll hier jedoch nicht näher eingegangen werden, da ihr Aufbau weitgehend beliebig sein kann; derartige Auswerteschaltungen sind zudem käuflich erwerbbar.

Ein Shuntwiderstand Rs ist im Meßwertaufnehmer 1 zwischen die Shuntleitung Lsh und die Brückenwiderstände R3, R4 bzw. die Meßleitung LM1 geschaltet. Durch Schließen des ersten Shuntschalters S1 wird somit der Shuntwiderstand Rs parallel zum Brückenwiderstand R4 geschaltet, so daß die Meßbrücke 3 definiert verstimmt wird. In gleicher Weise wird durch Schließen des zweiten Shuntschalters S2 der Shuntwiderstand Rs parallel zum Brückenwiderstand R3 gelegt. Hierdurch kann eine "Shuntkalibrierung" des gesamten Meßsystems vorgenommen werden, um diese zu eichen (Kalibrierbetrieb).

Der Meßwertaufnehmer 1 ist nun mit einem Kennungsgeber 8 versehen, der unter anderem einen Speicherbaustein mit zugeordneter Steuerlogik 9 umfaßt. In diesem Speicherbaustein sind Aufnehmer- Kennungsdaten des Meßwertaufnehmers 1 abgelegt. Dies können neben Korrekturdaten zum Ausgleich von statischen und/oder dynamischen Wandlungseigenschaften des physikalisch elektrischen Wandlers 2, wie z.B. für Stärkungs- und Nullpunktfehler, Nichtlinearitäten usw. sein. Ferner können noch Betriebsdaten für den Meßwertaufnehmer bzw. den physikalisch elektrischen Wandler 2, wie z. B. die Betriebsspannung sowie Däten über den Einsatzort des Meßwertaufnehmers in diesem Speicherbaustein abgelegt sein.

Um nun diese im Kennungsgeber 8 digital vorliegenden Daten für die Konfigurierung bzw. Parametrierung der nachfolgenden Auswerteschaltung 5 bzw. dem daran angeschlossenen Rechner ohne zusätzliche Leitungen vom Speicherbaustein zu letzteren übertragbar und letztlich verfügbar zu machen, wird nun der Kennungsgeber 8 mit wenigstens einem von der Steuerlogik 9 steuerbaren Schaltelement (elektrisch gesteuerter erster Hilfsshuntschalter Sh+) ausgestattet, mit dem ein Hilfsshuntwiderstand Rsh+ parallel zum Brückenwiderstand R4 geschaltet werden kann. Erforderlichenfalls kann ferner in gleicher Weise ein zweiter Hilfsshuntschalter Sh- vorgesehen werden, welcher einen zweiten Hilfsshuntwiderstand Rsh- parallel zum Brückenwiderstand R3 schaltet.

Die elektrisch gesteuerten Schalter (Hilfsshuntschalter Sh+, Sh-) sind gegenüber den überbrückten oder zu überbrückenden Teilen des Aufnehmers oder des elektrisch-physikalischen Wandlers im nicht angesteuerten Zustand als hochohmige und weitgehend kapazitätsfreie Schaltelemente ausgeführt, bevorzugt als Transistoren, Feldeffekttransistoren oder Analogschalter).

Der Kennungsgeber 8 bzw. dessen Steuerlogik 9 kann nun wenigstens einen dieser beiden Hilfsshuntschalter Sh+, Sh- im Rhythmus eines seriell aus dem Speicher auszulesenden, die Kennungsdaten beinhaltenden Datenbitstroms schließen oder öffnen. Auf diese Weise wird die Meßbrücke beim Schließen eines dieser Schalter definiert verstimmt, d.h., die binär digitalen Daten des Speicherbausteins werden in einen Informationsstrom von definierten (analogen) elektrischen Spannungsimpulsen (auf den Meßleitungen (Lm1, Lm2) transformiert. Die nachfolgende Auswerteschaltung 5 oder ein dieser nachgeschalteter Rechner kann aus den Pegelschwankungen auf den analogen Meßleitungen Lm1 und Lm2 die Kennungsdaten digital regenerieren. Diese Kennungsdaten können dann im Meßbetrieb zur Korrektur der vom physikalischen Wandler gelieferten Daten innerhalb der Auswerteschaltung oder dem nachfolgenden Rechner herangezogen werden (Betriebsspannungseinstellung, Einstellen des Verstärkungsfaktors und des Nullpunkts usw.).

Dieser Prozeß der Datenübertragung (Identifizierbetrieb) wird hierbei über die Shuntleitung Lsh angestoßen, wozu letztere mit dem Kennungsgeber 8 verbunden ist. Der Kennungsgeber 8 wird hierzu mit einer Schaltung ausgestattet, welche auf einen speziellen Bitmusterstrom auf der Shuntleitung anspricht, mit der die Betriebsarten Meßbetrieb, Kalibrierbetrieb und Identifizierbetrieb (zur Übertragung der Kennungsdaten) eingeleitet bzw. umgeschaltet werden kann.

Durch diese Mehrfachnutzung der Shuntleitung ist es somit möglich, ohne zusätzliche Leitungen die Übertragung von Kennungsdaten vom Kennungsgeber zur Auswerteschaltung (und umgekehrt) zu erreichen.

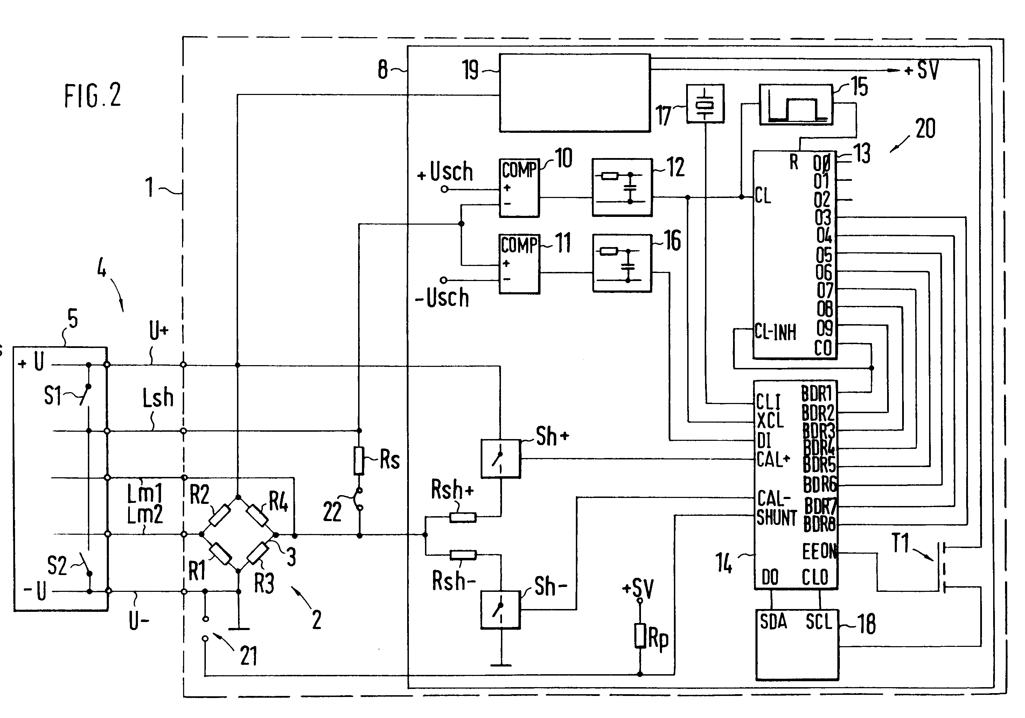

In Fig. 2 ist ein derartiger Kennungsgeber 8 näher gezeigt. Gleiche Bauteile tragen wiederum dieselben Bauteilbezeichnungen wie in Fig. 1. Ein erster Komparator 10 vergleicht den Pegel auf der Shuntleitung Lsh mit einer positiven Umschaltschwelle +Usch, wodurch ein Schließen des ersten Shuntschalters S1 nachgewiesen werden kann. Ein zweiter Komparator 11 vergleicht den Pegel auf der Shuntleitung Lsh mit einem negativen Umschaltpegel -Usch, um ein Schließen des Shuntschalters S2 zu detektieren. Impulse am Ausgang des ersten Komparators 10 werden über eine erste Filterschaltung 12, von Störimpulsen befreit, einem Zähleingang CL eines Betriebsartzählers 13 sowie einem Eingang XCL einer Steuerschaltung 14 zugeführt. Ein erstes Zeitglied 15 (Zeitfensterdiskriminator) erfaßt einen längeren Impuls am Zähleingang des Betriebsartzählers und setzt diesen über einem Rücksetzeingang R zurück (Übergang in den Meß- oder Kalibrierbetrieb).

Schließlich ist noch der Komparator 11 über eine der Störsignalunterdrückung dienende zweite Filterschaltung 16 mit einem Eingang DI der Steuerschaltung 14 verbunden. Ein Taktgenerator 17 dient der Bereitstellung eines Systemtakts für die Steuerschaltung 14 (Eingang CLI). Die Steuerschaltung 14 schließlich reagiert auf Signale am Ausgung der ersten Filterschaltung 12 und der zweiten Filterschaltung 16 sowie der Zählausgänge O0̸ bis 09 und CO des Betriebsartzählers 13. In Abhängigkeit von diesen Signalen steuert die Steuerschaltung 14 einen seriellen elektrisch lösch- und wiederbeschreibbaren nichtflüchtigen-Speicherbaustein (EEPROM) 18 sowie die Hilfsshuntschalter Sh+, Sh- an.

Der Kennungsgeber 8 umfaßt ferner noch ein Stromversorgungsteil 19, das der Stromversorgung aller aktiven Bauteile des Kennungsgebers dient. Das Stromversorgungsteil 19 kann hierbei eine Spannungsverdopplerschaltung und/oder eine Spannungsstabilisierschaltung enthalten. Schließlich kann die Steuerschaltung 14 im normalen Meßbetrieb Bauteile mit höherem Energieverbrauch mittels eines Feldeffekttransistors T1 von der Stromversorgung 19 trennen (z. B. den Speicherbaustein 18).

Die Funktion der gesamten Anordnung erklärt sich wie folgt:
Über die Shuntschalter S1 und S2 innerhalb der Auswerteschaltung 5 kann die Shuntleitung Lsh gegen positive Betriebsspannung +U und negative Betriebsspannung -U geschaltet werden. Die Komparatoren 10 und 11 vergleichen den Signalpegel auf der Shuntleitung Lsh mit den Umschaltschwellen +Usch, -Usch und geben bei Über- bzw. Unterschreiten dieser Umschaltschwellen über die Filter 12 und 16 Signale an die aus Zeitglied 15, Betriebsartzähler 13 und Steuerschaltung 14 bestehende, steuernde Schaltung 20 ab. Die steuernde Schaltung 20 reagiert auf definierte Impulse oder eine definierte Impulsfolge auf der Shuntleitung Lsh. Durch Aufschalten derartiger Impulse oder Impulsfolgen mittels der Shuntschalter S1, S2 ist der Kennungsgeber durch die steuernde Schaltung 20 in seiner Betriebsart (Meßbetrieb, Kalibrierbetrieb, Identifizierbetrieb) umschaltbar.

Im Meßbetrieb werden die Hilfsshuntschalter Sh+, Sh- nicht angesteuert, so daß diese hochohmig sind und so die Meßwerterfassung weitgehend unbeeinflußt lassen. Zusätzlich werden Bauteile mit höherem Stromverbrauch, wie z. B. der Speicherbaustein 18, über den nicht angesteuerten Feldeffekttransistor T1 von der Stromversorgung 19 getrennt.

Im Kalibrierbetrieb ist der physikalisch-elektrische Wandler 2 (die Meßbrücke 3) durch die Shuntschalter S1, S2 und den Shuntwiderstand Rs durch Dauerbetätigung der Shuntschalter S1, S2 definiert verstimmbar. Im Identifizierbetrieb kann die steuernde Schaltung durch Ansteuerung der Hilfsshuntschalter Sh+, Sh- , die die Hilfsshuntwiderstände Rsh+, Rsh- gegen positive Betriebsspannung +U bzw. negative Betriebsspannung -U im Rhythmus des seriell aus dem Speicherbaustein ausgelesenen Datenbitstroms schalten, die im Speicherbaustein abgelegten Kennungsdaten zur Auswerteschaltung 5 übertragen. Dort oder in einem nachgeschalteten Rechner können aus den analogen Signalen auf den Meßleitungen Lm1, Lm2 bzw. aus den Änderungen dieser Signale die Korrekturdaten regeneriert werden.

Das Aktivieren der Übertragung der Kennungsdaten bzw. das Einleiten des Identifizierbetriebs geschieht nun durch Aufschalten einer bestimmten ersten Anzahl von Impulsen definierter erster Impulsbreite auf die Shuntleitung Lsh mittels des ersten Shuntschalters S1. Über den ersten Komparator 10 und die Filterschaltung 12 und ein nicht gezeigtes Zeitglied (Zeitfensterdiskriminator) innerhalb des Betriebsartzählers 13, das prüft, ob die Breite des durch den ersten Shuntschalter S1 erzeugten Impulses nicht breiter als die erste Impulsbreite ist, wird der Betriebsartzähler 13 hochgezählt.

Erreicht der als Dezimalzähler ausgeführte Betriebsartzähler 13 den Zählerstand 3, so erfolgt das Einleiten des Identifizierbetriebs. Die Steuerschaltung 14 erzeugt daraufhin an ihrem Ausgang CLO ein Taktsignal, mit dem der Takteingang SCL des seriellen Speicherbausteins beaufschlagt wird. Ferner wird über den Ein-/Ausgang DO ein Steuersignal und eine Startadresse an den Ein- /Ausgang SDA des Speicherbausteins 18 ausgegeben, worauf dieser das entsprechende Datenwort über den Ein- /Ausgang SDA an den Ein-/Ausgang DO der Steuerschaltung 14 ausgibt.

Diese setzt das Datenwort entweder durch Ausgeben von Ansteuerimpulsen für den ersten Hilfsshuntschalter Sh+ über den Ausgang CAL+ in ein asynchrones Datenwort oder durch Ansteuern beider Hilfsshuntschalter Sh+, Sh- jeweils über die Ausgänge CAL+, CAL- in ein asynchrones Drei-Pegel-Signal auf den Meßleitungen LM1, LM2 um, bei dem dem über den ersten Hilfsshuntschalter Sh1 erzeugten Datenwort ein Taktsignal mittels des zweiten Hilfsshuntschalters Sh2 überlagert wird oder umgekehrt. Danach wird durch Senden eines Acknowledge-Signals über den Ein-/Ausgang DO das nächste Datenwort von der darauffolgenden Speicherzelle des Speicherbausteins 18 angefordert und entsprechend zur Auswerteschaltung 5 übertragen. Dieser Vorgang wiederholt sich solange, bis der Speicherbaustein 18 ausgelesen ist oder ein entsprechendes Datenwort im Speicherbaustein 18 ein Ende der Übertragung erkennen läßt (repetierende Ausgabe).

Mit dem Betriebsartzähler 13 ist es nun möglich, durch Aufschalten weiterer Impulse definierter erster Impulsbreite auf die Shuntleitung mittels des Shuntschalters S1 entweder Übertragungsparameter für die Übertragung der Kennungsdaten einzustellen (erste Version) oder eine Startadresse für den Ausleseprozeß aus dem Speicherbaustein 18 zu variieren (zweite Version).

In der ersten Version kann durch Aufschalten einer zweiten Anzahl von (bis zu fünf weiteren) Impulsen erster Impulsbreite die Datenübertragungsgeschwindigkeit (Baudrate) für die Datenübertragung zur Auswerteschaltung stufenweise von 9600 Baud an vermindert werden (4800 Baud, 2400 Baud,...). Damit ist es möglich, die Datenübertragung an das Zeitverhalten der nachfolgenden Auswerteschaltung anzupassen. Dort sind nämlich in der Regel Tiefpaßfilter mit einer bestimmten Grenzfrequenz in die Meßkette geschaltet. Es muß somit gewährleistet sein, daß diese Tiefpaßfilter den Datenbitstrom vom Meßwertaufnehmer bzw. dem Kennungsgeber 8 passieren lassen.

In der zweiten Version ist es möglich, durch Aufschalten von drei Impulsen auf die Shuntleitung Lsh mittels des Shuntschalters S1 den Identifizierbetrieb einzuleiten und den Speicherbaustein 18 ab der niedrigsten Startadresse (beispielsweise 0000) auszulesen. Durch Aufschalten einer dritten Anzahl von (bis zu fünf weiteren) Impulsen erster Impulsbreite auf die Shuntleitung Lsh kann diese Startadresse stufenweise erhöht werden. Hierdurch ist es möglich, den Ausleseprozess zu verkürzen, wenn lediglich Daten ab einer bestimmten Anfangsadresse von Interesse sind.

Durch Aufschalten einer bestimmten vierten Anzahl (zehn) von Impulsen definierter erster Impulsbreite auf die Shuntleitung Lsh mittels des ersten Shuntschalters kann der Kennungsgeber in einen Direktzugriffsbetriebszustand überführt werden, in dem Daten direkt auf bestimmte Speicherplatzadressen bzw. von beliebigen Speicherplatzadressen eingelesen oder ausgelesen werden können.

Das Einlesen bzw. Auslesen von Daten im Direktzugriffs-Betriebszustand erfolgt durch Aufschalten eines mittels des ersten und zweiten Shuntschalters erzeugten Drei-Pegel-Signals auf die Shuntleitung Lsh. Hierzu ist es jedoch notwendig, daß die Shuntschalter S1 und S2 selbst elektrisch steuerbar sind und von einem Rechner, der in der Auswerteschaltung integriert oder dieser nachgeschaltet sein kann bzw. von einem Programmiergerät gesteuert werden können.

Mittels des zweiten Shuntschalters S2 erfolgt die bitserielle Eingabe von Steuerbefehlen, Adressen und Daten für das Einlesen von Daten in den Speicherbaustein 18, während für das Auslesen von Daten lediglich Steuerbefehle und Adressen mittels des zweiten Shuntschalters S2 generiert werden. Mittels des ersten Shuntschalters S1 wird in beiden Fällen den Steuer-, Adress- und Datenwörtern ein Taktsignal synchron überlagert. Die steuernde Schaltung 20 bzw. die Steuerschaltung 14 setzt diese Drei-Pegel-Signale in entsprechende Ansteuersignale für den Speicherbaustein 18 um. Das Auslesen der entsprechend adressierten Speicherzellen erfolgt, wie oben beschrieben, mittels der Hilfsshuntschalter Sh+, Sh- und Hilfsshuntwiderstände Rsh+, Rsh- über die Meßleitungen Lm1, Lm2 über Drei-Pegel-Signale.

Es soll nicht unerwähnt bleiben, daß mit dem Einleiten des Direktzugriffs-Betriebszustands der Betriebsartzähler 13 über den Eingang CL-INH für weitere Impulse definierter erster Impulsbreite am Eingang CL gesperrt wird.

Auf das Aufschalten eines Impulses definierter zweiter Impulsbreite auf die Shuntleitung Lsh mittels des Shuntschalters S1 spricht das Zeitglied 15 (Zeitfensterdiskriminator) an. Durch das Erkennen dieses Impulses mit wenigstens doppelt so großer Impulsbreite wie die Impulse definierter erster Impulsbreite wird der Betriebsartzähler 13 bzw. die steuernde Schaltung 20 zurückgesetzt und der Meßwertaufnehmer geht in den Meßbetrieb über.

Der Kalibrierbetrieb wird dagegen durch noch länger andauerndes Schließen des Shuntschalters S1 oder S2 eingeleitet, so daß dieser Betriebsart praktisch das Zurücksetzen der steuernden Schaltung 20 vorausgeht. Der Kennungsgeber ist dann außer Betrieb, und über die Shuntschalter S1 und S2 wird der Shuntwiderstand Rs parallel zum einen Brückenzweg R2, R4 oder zum anderen Brückenzweig R1, R3 gelegt.

Durch festverdrahtete Logik (mittels Drahtbrücken 21 und 22) kann von der Shuntkalibrierung mittels der Shuntschalter S1 und S2 und dem Shuntwiderstand Rs auf Shuntkalibrierung mittels der Hilfsshuntschalter Sh+, Sh- und der Hilfsshuntwiderstände Rsh+, Rsh- umgeschaltet werden. Hierzu ist die Drahtbrücke 22 aufzutrennen und eine Drahtbrücke 21 einzuführen, so daß der Shuntwiderstand Rs von der Meßbrücke getrennt ist und der über einen Pull-Up-Widerstand Rp an positiver Betriebsspannung Sv vom Stromversorgungsteil 19 liegende Eingang SHUNT des Steuerbausteins 14 auf das Potential -U heruntergezogen wird. Über die Eingänge XCL und DI erfaßt die Steuerschaltung 14 das Betätigen der Shuntschalter S1 bzw. S2 über einen längeren Zeitraum, der oberhalb der zweiten Impulsbreite liegt, und steuert in Abhängigkeit davon die Hilfsshuntschalter Sh+ und Sh- an.

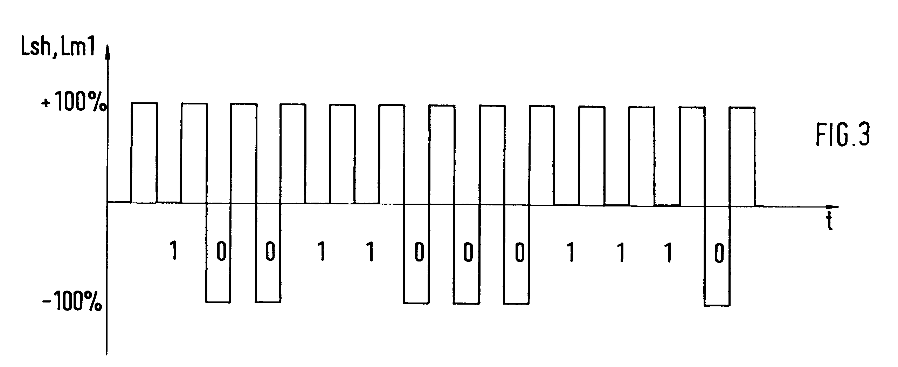

In Fig. 3 ist ferner ein Beispiel eines Drei-Pegel-Signals, wie es im Direktzugriffs-Modus auf die Shuntleitung Lsh mittels der Shuntschalter S1 und S2 aufgeschaltet wird bzw. wie es als Spannungssignal auf den Meßleitungen Lm1, Lm2 bei Datenübertragung vom Kennungsgeber 8 zur Auswerteschaltung 5 durch Ansteuern der Hilfsshuntschalter Sh+, Sh- durch die Steuerschaltung entsteht, gezeigt. Im unteren Quadranten ist das Clocksignal dargestellt, während der obere Quadrant ein serielles Datum aus Nullen und Einsen enthält.

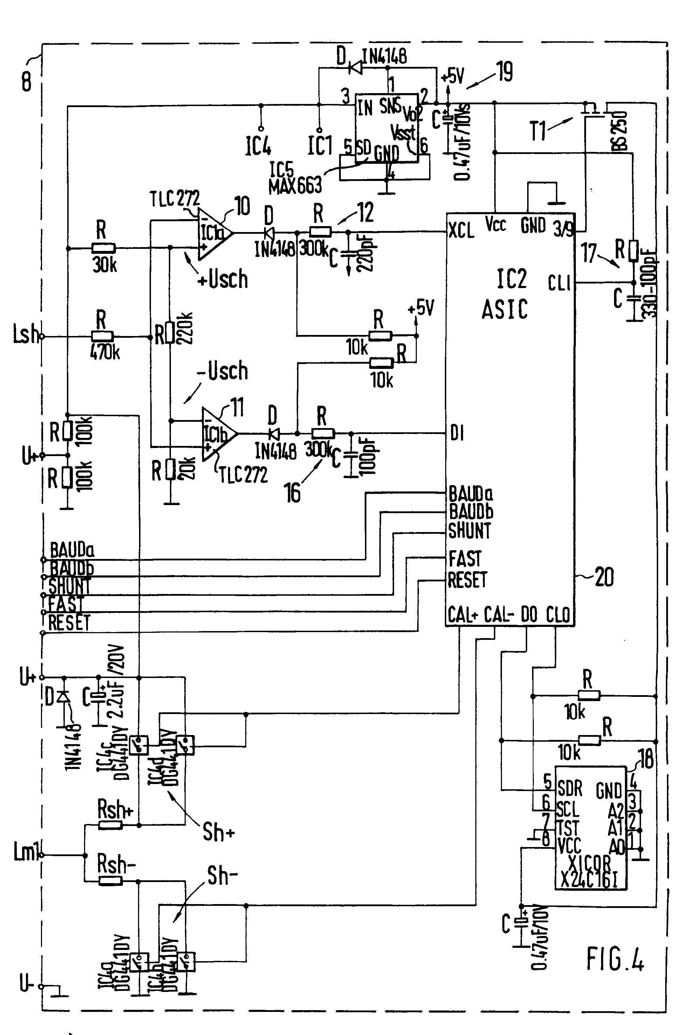

In Fig. 4 ist eine Realisierung des Kennungsgebers 8 gezeigt. Die steuernde Schaltung 20 faßt hierbei den Betriebsartzähler 13, den Steuerbaustein 14 und die Zeitfensterdiskriminatoren (Zeitglied 15) zusammen. Sie ist als sogenanntes ASIC (Application Specific Integrated Circuit) aufgebaut und erfüllt die gleiche Funktion wie die steuernde Schaltung 20. Als elektrisch lösch- und programmierbarer nichtflüchtiger Speicherbaustein mit seriellem Ein-/Ausgang (serielles EEPROM) ist ein integrierter Schaltkreis der Fa. XICOR der Spezifikation X24C16I gewählt.

Nachfolgend sind noch einmal die Funktionen des ASIC 20 zusammengefaßt: Der Baustein enthält die gesamte digitale Logik für das Einschalten der Betriebsarten, die Ablaufsteuerung für die repetierende Ausgabe aller Daten aus dem Speicherbaustein 18 ab einer eingestellten Adresse und die Direktzugriffs-Betriebsart. Die Ansteuersignale zum Einleiten und Modifizieren der verschiedenen Betriebsarten und zum Lesen und Beschreiben des Speicherbausteins 18 im Direktzugriffs-Betriebszustand werden über die Leitungen DI und XCL erfaßt. Die Ausgangssignale, die ein Mischsignal (Drei-Pegel-Signal) aus Takt und Daten darstellen, steuern über die Ausgänge CAL+ und CAL- die Hilfsshuntschalter Sh+ und Sh- an. Die erste Impulsbreite beträgt hier wahlweise 50 msec oder 3,2 msec, wobei durch festverdrahtete Logik (Drahtbrücke vom Eingang FAST gegen Masse) die entsprechende Umschaltung erfolgen kann.

Im Identifizierbetrieb (Zählerstand 3 bis 8) ist die Ablaufsteuerung für die repetierende Ausgabe der Daten aus dem Speicherbaustein 18 in Betrieb, wobei zählerstandsabhängig ab bestimmten Blockadressen Daten gesendet werden. Die Ablaufsteuerung hat die Aufgabe, im EEPROM 18 ein Taktsignal über die Verbindung CLO, SCL und eine Startadresse und einen Lesebefehl entsprechend der EEPROM-Spezifikation über die Verbindung D0-SDA zu liefern. Nach dem ersten, vom EEPROM 18 gesendeten Datenwort erzeugt die steuernde Schaltung taktsynchron nach dem achten Bit ein Acknowledge-Signal, welches das EEPR0M dazu veranlaßt, seinen internen Adreßzähler zu erhöhen und mit den folgenden Taktimpulsen das nächste Datenwort auszugeben usw. Gestoppt wird die fortlaufende Datenausgabe durch einen positiven Impuls auf der Shuntleitung Lsh, der mehr als doppelt so lang ist als der zum Ein- und Weiterschalten dienende Impuls erster Impulsbreite.

Im Direktzugriffsbetriebszustand (Zählerstand 9) wird über die Eingänge DI und XCL direkt auf das EEPROM 18 zugegriffen. Hierbei ist die Ablaufsteuerung für den repetierenden Betrieb außer Kraft gesetzt. Über die Shuntleitung Lsh eingelesene Informationen werden so umgeformt, daß ein Signalbild entsteht, das den Spezifikationen des EEPR0MS 18 entspricht. Auf diese Weise ist es möglich, von der Auswerteschaltung 5 (bei entsprechender Hard- und Software) direkt auf jede Speicherzelle zuzugreifen.

Die steuernde Schaltung 20 weist schließlich neben dem Eingang FAST zum Umschalten der Ansteuerimpulsabfrage und dem Eingang SHUNT zum Umschalten der externen Shuntkalibrierung auf interne, einen weiteren zusätzlichen Eingang zum Rücksetzen der steuernden Schaltung auf und zwei Eingänge BAUDa und BAUDb auf, mit denen durch festverdrahtete Logik (Schalten gegen das negative Potential -U) die Ausgabegeschwindigkeit der Daten in vier Stufen eingestellt werden kann.

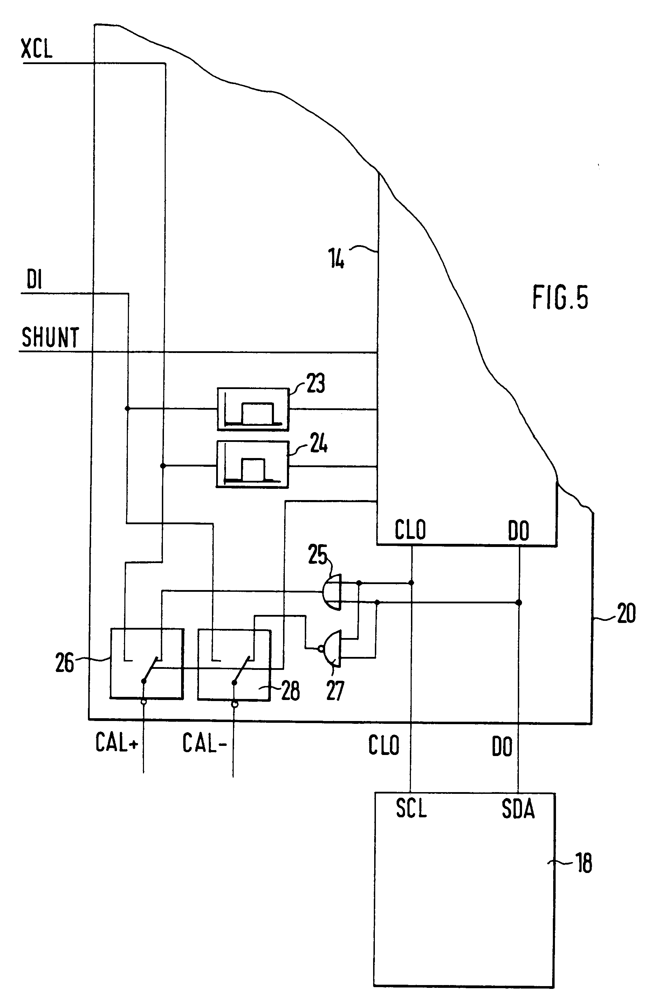

In Fig. 5 ist noch eine spezielle Ausgestaltung der steuernden Schaltung 20 dargestellt. Es hat sich nämlich gezeigt, daß es sinnvoll ist, die Flanken des Datenanteils und des Taktanteils an den Drei-Pegel-Signalen auf der Shuntleitung und den Meßleitungen geringfügig zeitlich zu versetzen. Hierdurch werden insbesondere mögliche Kurzschlüsse im System vermieden und die Wiedergewinnung der Daten- und Taktsignale aus dem Drei-Pegel-Signal wird vereinfacht.

Hierzu ist zwischen dem Eingang DI der steuernden Schaltung 20 und der Steuerschaltung 14 ein zweites Zeitglied 23 (Zeitfensterdiskriminator) geschaltet und zwischen den Eingang XCL der steuernden Schaltung 20 und der Steuerschaltung 14 ein drittes Zeitglied 24. Diese beiden Zeitfensterdiskriminatoren 23 und 24 prüfen, ob die ankommenden Datensignale in einem größeren Zeitfenster und die ankommenden Taktsignale in einem kleineren Zeitfenster liegen. Innerhalb der Steuerschaltung 14 findet dann letztendlich die Auftrennung des Drei-Pegel-Signals auf der Shuntleitung Lsh in die Daten- und Taktsignale zur Übertragung über den Ausgang ClO zum Eingang SCL des EEPR0M 18 und über den Ein-/Ausgang DO der steuernden Schaltung zum Ein-/Ausgang des EEPR0M 18 statt.

Über ein ODER-Gatter 25, das mit seinen Eingängen an den Verbindungen DO-SDA und CLO-SCL zwischen Steuerschaltung 14 und Speicherbaustein 18 liegt, werden die zwischen beiden Bausteinen ausgetauschten Daten miteinander verknüpft und über einen ersten invertierenden steuerbaren Schalter 26 an den Ausgang CAL+ ausgegeben. In gleicher Weise verknüpft ein negierendes UND-Gatter 27 die zwischen Steuerschaltung und Speicherbaustein ausgetauschten Daten und gibt sie über einen zweiten invertierenden steuerbaren Schalter 28 auf den Ausgang CAL- aus. Durch die mittels der Ausgänge CAL+, CAL- angesteuerten Hilfsshuntschalter Sh+, Sh- entsteht wiederum das Drei-Pegel-Signal auf den Meßleitungen Lm1, Lm2.

Der erste steuerbare Schalter 26 und der zweite steuerbare Schalter 28 können schließlich noch im Meßbetrieb und im Kalibrierbetrieb mit den Hilfsshuntschaltern Sh+, Sh- und den Hilfsshuntwiderständen Rsh+, Rsh- (Eingang SHUNT aktiv) die Ausgänge CAL+, CAL- von den Gattern 25 und 27 trennen und direkt auf die Eingänge XCL und DI schalten. Damit ist zum einen der ungestörte Meßbetrieb gewährleistet und zum anderen können im Kalibrierbetrieb die Hilfsshuntschalter Sh+, Sh- direkt mittels der Shuntschalter S1, S2 angesteuert werden. Zu bemerken ist schließlich noch, daß die besagte Schaltung im Identifizierbetrieb ein 'Mithören' der zum Kennungsgeber gesandten Signale über die Gatter 25, 27 ermöglicht.

Aufgrund der erforderlichen spezifischen Anpassung des steuernden Bausteins 20 an die Erfordernisse an Datenformat und Steuerbefehle des verwendeten Speicherbausteins erscheint es nicht sinnvoll, auf den internen Aufbau des als ASIC realisierten steuernden Baustein 20 noch näher einzugehen. Diese Spezifikationen sind dem jeweiligen Datenblatt des verwendeten seriellen EEPROMS zu entnehmen und das ASIC entsprechend auszugestalten.

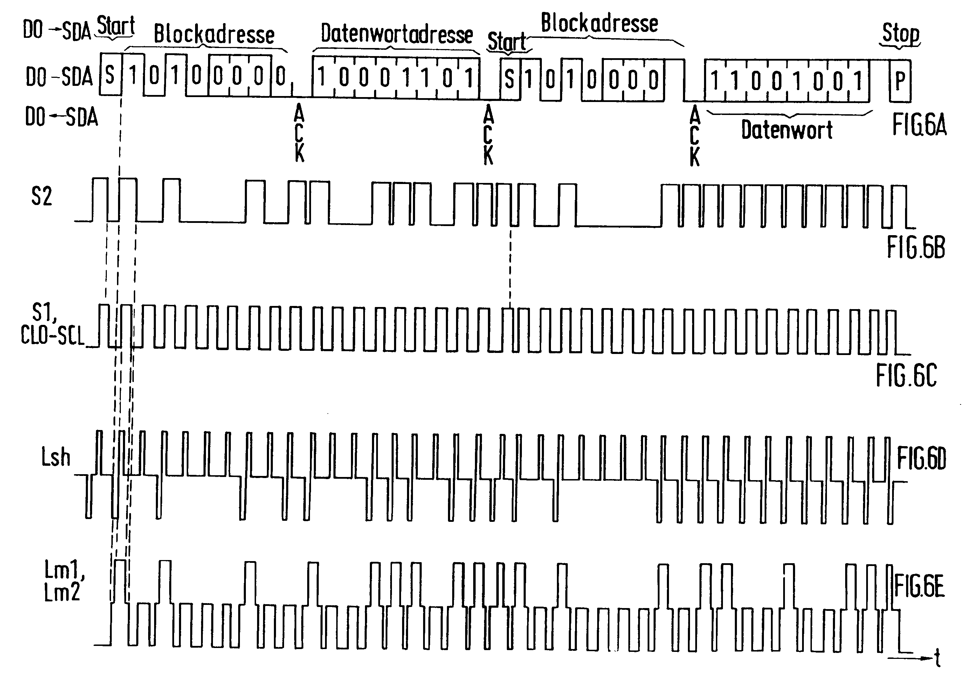

In Fig. 6 sind schließlich noch die Signal- und Datenformen auf den Leitungen DO-SDA und CLO-SCL zwischen steuernder Schaltung 20 und Speicherbaustein 18 gezeigt sowie die durch die Shuntschalter S1 und S2 zu erzeugenden Signale und die Signale auf der Shuntleitung Lsh und den Meßleitungen Lm1, Lm2. Die Signale stehen im selben zeitlichen Bezug zueinander.

Die Signalform nach Fig. 6a entspricht hierbei der Spezifikation des Speicherbausteins der Fa. XICOR vom Typ X24C16I und zeigt den Datenaustausch zwischen der steuernden Schaltung 20 und dem Speicherbaustein 18 beim Lesen von Daten. Die von der steuernden Schaltung 26 auf der Verbindung DO-SDA erzeugten Signale sind hierbei oberhalb des Signalstroms dargestellt (DO->SDA), während dte vom Speicherbaustein generierten Signale unterhalb des Signalstroms abgebildet sind (DO<-SDA).Nach Senden eines Startsignals (Startbits) durch die steuernde Schaltung 20 und einer Blockadresse (Slave-address) antwortet der Speicherbaustein 18 mit einem Acknowledge-Signal (ACK). Daraufhin sendet die steuernde Schaltung 20 eine Datenwortadresse (Word-address) oder auch mehrere Wortadressen, die jeweils wieder durch ein Acknowledge-Signal vom Speicherbaustein 18 quittiert werden. Auf ein erneutes Senden eines Startbits und der Blockadresse durch die steuernde Schaltung 20 antwortet die Speicherschaltung 18 wiederum durch ein Acknowledge-Signal, gefolgt von jeweils einem Datenwort aus der angeforderten Adresse. Die steuernde Schaltung 20 quittiert jedes ankommende Datenwort mit einem Acknowledge-Signal und sendet, wenn alle Datenworte ausgelesen sind, ein Stopsignal (Stopbit), mit dem die Datenübertragung zwischen beiden Bausteinen beendet wird.

Fig. 6b zeigt das Signalbild, das zum Erreichen des Signalbilds nach Fig. 6a mittels des zweiten Shuntschalters S2 zu erzeugen ist.

In Fig. 6c ist das mittels des ersten Shuntschalters S1 zu erzeugende Signalbild dargestellt, das in gleicher Weise auf der Verbindung zwischen den Eingängen CL0 und SCL der Bausteine 18 und 20 entsteht. Bei genauerer Betrachtung stellt man fest, daß die Impulse des Taktsignals außer beim Startbit immer innerhalb der Impulse des Datensignals liegen. Lediglich beim Startbit fällt die abfallende Flanke des Datensignals mit einem (positiven) Impuls des Taktsignals zusammen.

Fig. 6d zeigt schließlich das durch die Betätigung der Shuntschalter S2 und S1 auf der Shuntleitung Lsh entstehende Signalbild, während in der Fig. 6e das Signalbild auf den Meßleitungen Lm1, Lm2 abgebildet ist.

## Patentansprüche

1. Meßwertaufnehmer (1) zur Erfassung einer physikalischen Größe, welche über einen physikalisch- elektrischen Wandler (2) in eine äquivalente analoge elektrische Größe umgesetzt und von einer nachgeschalteten, baulich nicht mit dem Meßwertaufnehmer (1) vereinigten, an diesen über elektrische, der Meßwertübertragung und/oder der Energieversorgung des Meßwertaufnehmers dienende Leitungen (Lm1, Lm2, +Us, -Us) angeschlossenen Auswerteschaltung (5) in weiterverarbeitbare Größen, vorzugsweise digitale Daten umgesetzt wird (Meßbetrieb), wobei der physikalisch- elektrische Wandler (2) in einer Brückenschaltung (Meßbrücke (3)) verschaltet ist und einzelne Zweige der Meßbrücke (3) zu Kalibrierzwecken durch Parallelschalten eines auf dem Meßwertaufnehmer (1) angeordneten Shuntwiderstands (Rs) über der Auswerteschaltung (5) zugeordnete Schalter (Shuntschalter S1, S2) und eine diese mit dem Shuntwiderstand verbindende Shuntleitung Lsh definiert verstimmt werden können (Shuntkalibrierung, Kalibrierbetrieb), und wobei im Meßwertaufnehmer (1) ein Kennungsgeber (8) integriert ist, der einen nichtflüchtigen Speicherbaustein (9, 18) mit Korrekturdaten (Aufnehmer-Kennungsdaten) des Meßwertaufnehmers (1) umfaßt sowie ein parallel zu einem Zweig (R2, R4; R1, R3) der Meßbrücke (3) liegendes steuerbares Schaltelement (Sh+, Sh-) zur definierten Verstimmung der Meßbrücke (13) im angesteuerten Zustand, wobei der Kennungsgeber (8) bei einer aktivierbaren Übertragung der Korrekturdaten zur Auswerteschaltung (5) das steuerbare Schaltelement (Sh+, Sh-) im Rhythmus des seriell aus dem Speicherbaustein (9, 18) ausgelesenen Datenbitstroms an- und abschaltet, und die Auswerteschaltung (5) oder ein nachgeschalteter Rechner die analogen Signale bzw. deren Änderungen an der Meßbrücke (3) erfaßt und daraus die Korrekturdaten regeneriert, welche zur Korrektur der vom physikalisch- elektrischen Wandler (2) gelieferten elektrischen Größen herangezogen werden können (Identifizierbetrieb), **dadurch gekennzeichnet,** daß von dem Kennungsgeber (8) zu wenigstens einem der Schalter (S1, S2) und dem Shuntwiderstand (Rs) wenigstens ein Hilfsshuntwiderstand (Rsh+, Rsh-) über elektrisch steuerbare Hilfsshuntschalter (Sh+, Sh-) parallelschaltbar ist, und daß der Kennungsgeber (8) eine auf definierte Impulse oder eine definierte Impulsfolge auf der Shuntleitung (Lsh) ansprechende, den Kennungsgeber (8) steuernde Schaltung (20) aufweist, und der Kennungsgeber (8) durch Aufschalten derartiger Impulse oder Impulsfolgen auf die Shuntleitung (Lsh) mittels der Shuntschalter (S1, S2) in seiner Betriebsart (Meßbetrieb, Kalibrierbetrieb, Identifizierbetrieb) umschaltbar ist, wobei in der Betriebsart
- Meßbetrieb und Kalibrierbetrieb der Kennungsgeber (8) derart geschaltet ist, daß die Meßwerterfassung weitestgehend unbeeinflußt vom Kennungsgeber (8) ist,
- Kalibrierbetrieb der physikalisch- elektrische Wandler (2) durch die Shuntschalter (S1, S2; Sh+, Sh-) und den Shuntwiderstand (Rs; Rsh+, Rsh-) definiert verstimmbar ist,
- Identifizierbetrieb durch Ansteuerung der Hilfsshuntschalter (Sh+, Sh-) mittels der steuernden Schaltung (20) die Korrekturdaten über die Meßleitungen (Lm1, Lm2) vom Kennungsgeber (8) zur Auswerteschaltung übertragbar sind.

2. Meßwertaufnehmer nach Anspruch 1, **dadurch gekennzeichnet,** daß die steuernde Schaltung (20) wenigstens eine Zählschaltung (Betriebsartzähler, 13) aufweist, die die Impulslänge und/oder die Impulsanzahl der Impulse oder Impulsfolge auf der Shuntleitung (Lsh) erfaßt und in Abhängigkeit davon die Betriebsart umschaltet und in der Betriebsart Identifizierbetrieb die Übertragung der Korrekturdaten initialisiert und steuert.

3. Meßwertaufnehmer nach Anspruch 2, **dadurch gekennzeichnet,** daß die steuernde Schaltung (20) des Kennungsgebers (8) der Steuerung und Adressierung des Speicherbausteins (18), bzw. der Aufbereitung und Umsetzung von Steuerbefehlen, Daten und Adressen vom bzw. zum Speicherbaustein (18) dient.

4. Meßwertaufnehmer nach wenigstens einem der Ansprüche 2 oder 3, **dadurch gekennzeichnet,** daß über die Shuntleitung (Lsh) Steuerinformationen, Adressen und Daten von der Auswerteschaltung (5) zum Kennungsgeber (8) zum Einlesen von Aufnehmer- Kennungsdaten übertragbar sind.

5. Meßwertaufnehmer nach wenigstens einem der vorangehenden Ansprüche, **dadurch gekennzeichnet,** daß die Aktivierung der Übertragung der Kennungsdaten zur Auswerteschaltung (5) (Einleiten des Identifizierbetriebs, Initialisierung des Kennungsgebers) durch Aufschalten einer bestimmten ersten Anzahl von Impulsen definierter erster Impulsbreite auf die Shuntleitung (Lsh) mittels des ersten Shuntschalters (S1) erfolgt.

6. Meßwertaufnehmer nach wenigstens einem der vorangehenden Ansprüche, **dadurch gekennzeichnet,** daß die Festlegung der Übertragungsparameter für die Übertragung der Kennungsdaten durch Aufschalten einer bestimmten zweiten Anzahl von Impulsen definierter erster Impulsbreite auf die Shuntleitung (Lsh) mittels des ersten Shuntschalters (S1) erfolgt.

7. Meßwertaufnehmer nach wenigstens einem der vorangehenden Ansprüche 1 bis 5, **dadurch gekennzeichnet,** daß die Festlegung einer Startadresse der Kennungsdaten zu deren Übertragung durch Aufschalten einer bestimmten dritten Anzahl von Impulsen definierter erster Impulsbreite auf die Shuntleitung (Lsh) mittels des ersten Shuntschalters (S1) erfolgt.

8. Meßwertaufnehmer nach wenigstens einem der vorangehenden Ansprüche, **dadurch gekennzeichnet,** daß durch Aufschalten einer bestimmten vierten Anzahl von Impulsen definierter erster Impulsbreite auf die Shuntleitung (Lsh) mittels des ersten Shuntschalters (S1) der Kennungsgeber (8) in einen Direktzugriffs- Betriebszustand überführbar ist, in dem Daten direkt auf bestimmte Speicherplatzadressen bzw. von beliebigen Speicherplatzadressen des Speicherbausteins (18) über die Shuntleitung (Lsh) einlesbar bzw. über die Meßleitungen (Lm1, Lm2) auslesbar sind.

9. Meßwertaufnehmer nach Anspruch 8, **dadurch gekennzeichnet,** daß das Einlesen / Auslesen von Daten im Direktzugriffs- Betriebszustand durch Aufschalten eines mittels des ersten und zweiten Shuntschalters (S1, S2) erzeugten Dreipegelsignals auf die Shuntleitung (Lsh) erfolgt, das die steuernde Schaltung (20) des Kennungsgebers (8) in entsprechende Ansteuersignale für den Kennungsgeber (8) umsetzt, wobei mittels des zweiten Shuntschalters (S2) die bitserielle Eingabe von Steuerbefehlen, Adressen und Daten (Einlesen) / Steuerbefehlen und Adressen (Auslesen) erfolgt und wobei den Steuer-, Adreß- und Datensignalen ein mittels des ersten Shuntschalters (S1) erzeugtes Taktsignal synchron überlagert ist (Dreipegelsignal).

10. Meßwertaufnehmer nach Anspruch 9, **dadurch gekennzeichnet,** daß die Erzeugung des Dreipegelsignals derart erfolgt, daß Flanken des Taktsignals zeitlich versetzt zu Flanken des Steuer-, Adreß- oder Datensignals sind.

11. Meßwertaufnehmer nach wenigstens einem der vorangehenden Ansprüche, **dadurch gekennzeichnet,** daß durch Aufschalten eines Impulses definierter zweiter Impulsbreite auf die Shuntleitung (Lsh) mittels des ersten Shuntschalters (S1) eine Beendigung der Übertragung der Kennungsdaten bzw. eine Aktivierung der Shuntkalibrierung erfolgt.

12. Meßwertaufnehmer nach wenigstens einem der vorangehenden Ansprüche, daß die Übertragung der Kennungsdaten vom Kennungsgeber (8) zur Auswerteschaltung in asynchronem Datenformat erfolgt, wobei die steuernde Schaltung (20) des Kennungsgebers (8) mittels des zweiten oder ersten Hilfsshuntschalters (Sh-, Sh+) die bitserielle Ausgabe der Daten vornimmt und mittels des ersten oder zweiten Hilfsshuntschalters (Sh+, Sh-) dem Datensignal ein Taktsignal synchron überlagert (Dreipegelsignal).

13. Meßwertaufnehmer nach Anspruch 11, **dadurch gekennzeichnet,** daß die Übertragung der Kennungsdaten vom Kennungsgeber (9) zur Auswerteschaltung über die Meßleitungen (Lm1, Lm2) in asynchronem Datenformat mittels eines Dreipegelsignals erfolgt, zu dessen Erzeugung das invertierte Signal eines mit den Steuer-, Adreß- oder Datenströmen (DO-SDA) und Taktsignalströmen (CLO-SCL) zwischen Speicherbaustein (18) und steuernder Schaltung (20) beaufschlagten ODER-Gatters (25) den ersten Hilfsshuntschalter (Sh+) und das invertierte Signal eines mit denselben Signalströmen beaufschlagten NICHT-UND-Gatters (27) den zweiten Hilfsshuntschalter (Sh-) ansteuert.

14. Meßwertaufnehmer nach wenigstens einem der vorangehenden Ansprüche 1 bis 5 oder 7 bis 13, **dadurch gekennzeichnet,** daß die Festlegung bzw. Umschaltung von Übertragungsparametern mittels festverdrahteter Logik oder Kodierschaltern erfolgt.

15. Meßwertaufnehmer nach wenigstens einem der vorangehenden Ansprüche, **dadurch gekennzeichnet,** daß der Meßwertaufnehmer mittels festverdrahteter Logik (21, 22) oder Kodierschaltern von einer Shuntkalibrierung mittels der Shuntschalter (S1, S2) und dem Shuntwiderstand (Rs) auf Shuntkalibrierung mittels der Hilfsshuntschalter (Sh+, Sh-) und der Hilfsshuntwiderstande (Rsh+, Rsh-) umschaltbar ist.

16. Meßwertaufnehmer nach wenigstens einem der vorangehenden Ansprüche, dadurch gekennzeichnet, daß die erste und/oder zweite Impulsbreite der auf die Shuntleitung (Lsh) aufzuschaltenden Impulse mittels festverdrahteter Logik oder Kodierschaltern veränderbar ist.

17. Meßwertaufnehmer nach wenigstens einem der vorangehenden Ansprüche, **dadurch gekennzeichnet,** daß die Aufnehmer- Kennungsdaten neben den Korrekturdaten zum Ausgleich von statischen und/oder dynamischen Wandlungseigenschaften des Meßwertaufnehmers (1) und/oder Teilen der Auswerteschaltung (13), wie z. B. Verstärkungs-, Nullpunktfehlern, Nichtlinearitäten usw., zusätzlich Betriebsdaten für den Meßwertaufnehmer (1) bzw. für den physikalisch- elektrischen Wandler (2, 3), sowie Daten über den Einsatzort des Meßwertaufnehmers umfassen.

18. Meßwertaufnehmer nach wenigstens einem der vorangehenden Ansprüche, **dadurch gekennzeichnet,** daß Bausteine des Kennungsgebers (8) mit niedrigerem Energieverbrauch direkt und Bausteine (18) mit höherem Energieverbrauch unter Zwischenschaltung einer Stand- By- Schaltung an die Energieversorgung (Stromversorgungsteil 19) des physikalisch- elektrischen Wandlers (2) angeschlossen sind.

19. Meßwertaufnehmer wenigstens einem der vorangehenden Ansprüche, **dadurch gekennzeichnet,** daß die elektrisch gesteuerten Schalter (Hilfsshuntschalter Sh+, Sh-) gegenüber den überbrückten oder zu überbrückenden Teilen (R2, R4; R1, R2) des Aufnehmers oder des physikalisch-elektrischen Wandlers (2, 3) als im nicht angesteuerten Zustand hochohmige und weitgehend kapazitätsfreie Schaltelemente ausgeführt sind.

20. Meßwertaufnehmer nach Anspruch 19, **dadurch gekennzeichnet,** daß die Schaltelemente Transistoren sind.

21. Meßwertaufnehmer nach Anspruch 20, **dadurch gekennzeichnet,** daß die Schaltelemente Feldeffekttransistoren sind.

22. Meßwertaufnehmer nach Anspruch 19, **dadurch gekennzeichnet,** daß die Schaltelemente Analogschalter sind.

23. Meßwertaufnehmer nach wenigstens einem der vorangehenden Ansprüche, **dadurch gekennzeichnet,** daß der Speicherbaustein (18) ein lösch- und programmierbarer nichtflüchtiger Speicherbaustein mit seriellem Ein- / Ausgang ist.

## Claims

1. Measurement value sensor (1) for detecting a physical variable which is converted to an equivalent analog electrical variable by way of a physical-electrical transducer (2) and is converted (measuring mode) to variables which can be further processed, preferably digital data, by a downstream evaluating circuit (5) which is structurally not combined with the measurement value sensor (1) and is connected to the latter by way of electrical lines (Lm1, Lm2, +Us, -Us) serving to transmit measurement values and/or to supply energy to the measurement value sensor, the physical-electrical transducer (2) being connected in a bridge circuit (measuring bridge (3)) and it being possible for individual branches of the measuring bridge (3) to be tuned in a defined manner for calibrating purposes by connecting a shunt resistor (Rs) arranged on the measurement value sensor (1) in parallel by way of switches (shunt switches S1, S2) associated with the evaluating circuit (5) and a shunt line Lsh connecting the said switches to the shunt resistor (shunt calibration, calibrating mode), and there being integrated in the measurement value sensor (1) an identification generator (8) which comprises a non-volatile storage chip (9, 18) with correction data (sensor identification data) of the measurement value sensor (1) and a controllable switching element (Sh+, Sh-), lying parallel to a branch (R2, R4; R1, R3) of the measuring bridge (3), for the defined tuning of the measuring bridge (13) in the controlled state, the identification generator (8) switching the controllable switching element (Sh+, Sh-) on and off in the rhythm of the stream of data bits read out serially from the storage chip (9, 18) on an activatable transmission of the correction data to the evaluating circuit (5), and the evaluating circuit (5) or a downstream computer detecting the analog signals and the modifications thereof at the measuring bridge (3) and regenerating therefrom the correction data which can be used to correct the electrical variables supplied from the physical-electrical transducer (2) (identifying mode), characterized in that from the identification generator (8) to at least one of the switches (S1, S2) and the shunt resistor (Rs) at least one auxiliary shunt resistor (Rsh+, Rsh-) can be connected in parallel by way of electrically controllable auxiliary shunt switches (Sh+, Sh-), and in that the identification generator (8) has a circuit (20) which responds to defined pulses or a defined pulse sequence on the shunt line (Lsh) and controls the identification generator (8), and the identification generator (8) is switchable in its mode of operation (measuring mode, calibrating mode, identifying mode) by switching such pulses or pulse sequences onto the shunt line (Lsh) by means of the shunt switches (S1, S2), in the mode of operation
- measuring mode and calibrating mode the identification generator (8) being switched such that the detection of measurement values is as far as possible uninfluenced by the identification generator (8),
- calibrating mode the phyrical-electrical transducer (2) being tunable in a defined manner by the shunt switches (S1, S2; Sh+, Sh-) and the shunt resistor (Rs; Rsh+, Rsh-),
- identifying mode the correction data being transmittable by way of the measuring lines (Lm1, Lm2) from the identification generator (8) to the evaluating circuit by triggering the auxiliary shunt switches (Sh+, Sh-) by means of the controlling circuit (20).

2. Measurement value sensor according to Claim 1, characterized in that the controlling circuit (20) has at least one counting circuit (mode of operation counter, 13) which detects the pulse length and/or the pulse count of the pulses or pulse sequence on the shunt line (Lsh) and as a function thereof switches the mode of operation and in the mode of operation identifying mode initializes and controls the transmission of the correction data.

3. Measurement value sensor according to Claim 2, characterized in that the controlling circuit (20) of the identification generator (8) serves to control and address the storage chip (18) or to edit and transfer control commands, data and addresses from and to the storage chip (18).

4. Measurement value sensor according to at least one of Claims 2 or 3, characterized in that by way of the shunt line (Lsh) control information, addresses and data can be transmitted from the evaluating circuit (5) to the identification generator (8) for reading in sensor identification data.

5. Measurement value sensor according to at least one of the preceding claims, characterized in that the activation of the transmission of the identification data to the evaluating circuit (5) (initiation of the identifying mode, initialization of the identification generator) is effected by switching a predetermined first number of pulses of a defined first pulse width onto the shunt line (Lsh) by means of the first shunt switch (S1).

6. Measurement value sensor according to at least one of the preceding claims, characterized in that the determination of the transmission parameters for the transmission of the identification data is effected by switching a predetermined second number of pulses of a defined first pulse width onto the shunt line (Lsh) by means of the first shunt switch (S1).

7. Measurement value sensor according to at least one of the preceding Claims 1 to 5, characterized in that the determination of a start address of the identification data for the transmission thereof is effected by switching a predetermined third number of pulses of a defined first pulse width onto the shunt line (Lsh) by means of the first shunt switch (S1).

8. Measurement value sensor according to at least one of the preceding claims, characterized in that by switching a predetermined fourth number of pulses of a defined first pulse width onto the shunt line (Lsh) by means of the first shunt switch (S1) the identification generator (8) can be converted to a direct access operating state in which data can be read in by way of the shunt line (Lsh) or read out by way of the measuring lines (Lm1, Lm2) directly in response to predetermined storage location addresses or random storage location addresses of the storage chip (18).

9. Measurement value sensor according to Claim 8, characterized in that the reading in/reading out of data in the direct access operating state is effected by switching a three-level signal which is generated by means of the first and second shunt switches (S1, S2) onto the shunt line (Lsh), which three-level signal the controlling circuit (20) of the identification generator (8) converts into corresponding triggering signals for the identification generator (8), the bit-serial input of control commands, addresses and data (reading in)/control commands and addresses (reading out) being effected by means of the second shunt switch (S2), and a clock signal generated by means of the first shunt switch (S1) being synchronously overlaid on the control, address and data signals (three-level signal).

10. Measurement value sensor according to Claim 9, characterized in that the generation of the three-level signal is effected such that edges of the clock signal are offset in time with respect to edges of the control, address or data signal.

11. Measurement value sensor according to at least one of the preceding claims, characterized in that a completion of the transmission of the identification data or an activation of the shunt calibration is effected by switching a pulse of a defined second pulse width onto the shunt line (Lsh) by means of the first shunt switch (S1).

12. Measurement value sensor according to at least one of the preceding claims, characterized in that the transmission of the identification data from the identification generator (8) to the evaluating circuit is effected in asynchronous data format, the controlling circuit (20) of the identification generator (8) carrying out the bit-serial output of the data by means of the second or first auxiliary shunt switch (Sh-, Sh+) and synchronously overlaying a clock signal on the data signal by means of the first or second auxiliary shunt switch (Sh+, Sh-) (three-level signal).

13. Measurement value sensor according to Claim 11, characterized in that the transmission of the identification data from the identification generator (9) to the evaluating circuit is effected by way of the measuring lines (Lm1, Lm2) in asynchronous data format by means of a three-level signal, for the generation of which the inverted signal of an OR gate (25) acted upon by the control, address or data streams (DO-SDA) and clock signal streams (CLO-SCL) between storage chip (18) and controlling circuit (20) triggers the first auxiliary shunt switch (Sh+) and the inverted signal of a NAND gate (27) acted upon by the same signal streams triggers the second auxiliary shunt switch (Sh-).

14. Measurement value sensor according to at least one of the preceding Claims 1 to 5 or 7 to 13, characterized in that the determination or switching over of transmission parameters is effected by means of hard-wired logic or coding switches.

15. Measurement value sensor according to at least one of the preceding claims, characterized in that the measurement value sensor can be switched over by means of hard-wired logic (21, 22) or coding switches from a shunt calibration by means of the shunt switches (S1, S2) and the shunt resistor (Rs) to shunt calibration by means of the auxiliary shunt switches (Sh+, Sh-) and the auxiliary shunt resistors (Rsh+, Rsh-).

16. Measurement value sensor according to at least one of the preceding claims, characterized in that the first and/or second pulse width of the pulses to be switched onto the shunt line (Lsh) can be altered by means of hard-wired logic or coding switches.

17. Measurement value sensor according to at least one of the preceding claims, characterized in that the sensor identification data, besides the correction data for compensating static and/or dynamic transformation properties of the measurement value sensor (1) and/or parts of the evaluating circuit (13), such as amplification, zero point errors, non-linearities, etc., additionally comprises operating data for the measurement value sensor (1) or for the physical-electrical transducer (2, 3), as well as data on the location of use of the measurement value sensor.

18. Measurement value sensor according to at least one of the preceding claims, characterized in that chips of the identification generator (8) with a relatively low energy consumption are connected directly to the energy supply (current supply part 19) of the physical-electrical transducer (2) and chips (18) with a relatively high energy consumption are connected thereto with the interposition of a standby circuit.

19. Measurement value censor according to at least one of the preceding claims, characterized in that the electrically controlled switches (auxiliary shunt switches Sh+, Sh-), in contrast to the bridged parts or parts to be bridged (R2, R4; R1, R2) of the sensor or of the physical-electrical converter (2, 3), are constructed as switching elements which have high resistivity and are substantially capacitance-free in the untriggered states.

20. Measurement value sensor according to Claim 19, characterized in that the switching elements are transistors.

21. Measurement value sensor according to Claim 20, characterized in that the switching elements are field effect transistors.

22. Measurement value sensor according to Claim 19, characterized in that the switching elements are analog switches.

23. Measurement value sensor according to at least one of the preceding claims, characterized in that the storage chip (18) is an erasable and programmable non-volatile storage chip with serial input/output.

## Revendications

1. Capteur de valeurs de mesure (1) destiné à détecter une grandeur physique, qui est convertie par un convertisseur (10) électro-physique en une grandeur électrique analogique équivalente et qui est convertie en grandeur à traiter ultérieurement, de préférence en données numériques, par un circuit d'exploitation (5) monté en aval, non réuni de par sa construction avec le capteur de valeurs de mesure (1), raccordé à celui-ci par des lignes électriques (Lm1, Lm2, +Us, -Us) servant à la transmission des valeurs de mesure et/ou à l'alimentation en énergie du capteur de valeurs de mesure (mode mesure), le convertisseur (2) électrophysique étant monté dans un circuit à pont (pont de mesure (3)) et des branches isolées du pont de mesure (3) pouvant être désaccordées de manière définie, à des fins de calibrage, par montage en parallèle d'une résistance shunt (Rs) prévue sur le capteur de mesures (1), par des interrupteurs (interrupteurs shunt S1, S2) associés aux circuits d'exploitation (5) et par une ligne shunt Lsh, reliant ceux-ci à la résistance shunt (calibrage shunt, mode calibrage), et dans le capteur de valeurs de mesure (1) étant intégré un générateur de signaux d'identification qui comporte un composant (9, 18) de mémoire non volatile avec des données de correction (données d'identification du capteur) du capteur de valeurs de mesure (1), ainsi qu'un élément de commutation (Sh+, Sh-) commandable, parallèle à une branche (R2, R4 ; R1, R3) du pont de mesure (3) en vue du désaccord défini du pont de mesure (13) dans l'état commandé, le générateur de signaux d'identification (8) mettant l'élément de commutation (Sh+, Sh-) commandable en circuit et hors circuit, dans le cas d'une transmission activable des données de correction vers le circuit d'exploitation (5), au rythme du courant de bits de données extraites de la mémoire (9, 18), et le circuit d'exploitation (5) ou un ordinateur monté en aval détectant les signaux analogiques ou leurs variations sur le pont de mesure (3) et régénérant à partir de ceux-ci les données de correction qui peuvent être utilisées pour la correction des grandeurs électriques fournies par le convertisseur électrophysique (2) (mode identification), caractérisé en ce que du générateur de signaux d'identification (8) à au moins l'un des interrupteurs (S1, S2) et à la résistance shunt (Rs), une résistance shunt auxiliaire (Rsh+, Rsh-) au moins peut être montée en parallèle, par des interrupteurs shunt auxiliaires (Sh+, Sh-) commandés électriquement, et en ce que le générateur de signaux d'identification (8) comporte un circuit (20) commandant le générateur de signaux d'identification (8), réagissant à des impulsions définies ou à une séquence d'impulsions définie sur la ligne shunt (Lsh), et le générateur de signaux d'identification (8) peut être commuté dans son mode de fonctionnement (mode mesure, mode calibrage, mode identification), par envoi de ces impulsions ou séquences d'impulsions sur la ligne shunt (Lsh) au moyen des interrupteurs shunt (S1, S2),
- dans le mode mesure et dans le mode calibrage, le générateur de signaux d'identification (8) étant commandé de manière que la détection des valeurs de mesure soit pratiquement non influencée par le générateur de signaux d'identification (8),
- dans le mode calibrage, le convertisseur électrophysique (2) pouvant être désaccordé de manière définie par les interrupteurs shunt (S1, S2 ; Sh+, Sh-) et par la résistance shunt (Rs ; Rsh+, Rsh-),
- dans le mode identification, les données de correction étant transmises du générateur de signaux d'identification (8) au circuit d'exploitation, par commande des interrupteurs shunt auxiliaires (Sh+, Sh-), au moyen du circuit (20) de commande, par l'intermédiaire des lignes de mesure (Lm1, Lm2).

2. Capteur de valeurs de mesure selon la revendication 1, caractérisé en ce que le circuit (20) de commande comporte au moins un circuit de comptage (compteur mode de fonctionnement 13), qui détecte la longueur des impulsions et/ou le nombre d'impulsions ou de la séquence d'impulsions sur la ligne shunt (Lsh), et commute le mode de fonctionnement en fonction de ceux-ci et initialise et commande la transmission des données de correction, dans le mode identification.

3. Capteur de valeurs de mesure selon la revendication 2, caractérisé en ce que le circuit (20) de commande du générateur de signaux d'identification (8) sert à la commande et à l'adressage de la mémoire (18), ou à la préparation et à la conversion des instructions de commande, des données et des adresses à partir de la mémoire (18) ou vers celle-ci.

4. Capteur de valeurs de mesure selon l'une au moins des revendications 2 ou 3, caractérisé en ce que des informations de commande, des adresses et des données peuvent être transmises du circuit d'exploitation (5) au générateur de signaux d'identification (8), par la ligne shunt (Lsh), pour la mémorisation de données d'identification du capteur.

5. Capteur de valeurs de mesure selon l'une au moins des revendications précédentes, caractérisé en ce que l'activation de la transmission des données d'identification vers le circuit d'exploitation (5) (lancement du mode identification, initialisation du générateur de signaux d'identification) s'effectue par envoi d'un premier nombre déterminé d'impulsions d'une première largeur définie sur la ligne shunt (Lsh), au moyen du premier interrupteur shunt (S1).

6. Capteur de valeurs de mesure selon l'une au moins des revendications précédentes, caractérisé en ce que la définition des paramètres de transmission pour la transmission des données d'identification, par envoi d'un deuxième nombre déterminé d'impulsions d'une première largeur définie, sur la ligne shunt (Lsh), s'effectue au moyen du premier interrupteur shunt (F1).

7. Capteur de valeurs de mesure selon l'une au moins des revendications précédentes 1 à 5, caractérisé en ce que la définition d'une adresse de lancement des données d'identification en vue de leur transmission par envoi d'un troisième nombre déterminé d'impulsions, d'une première largeur définie, sur la ligne shunt (Lsh), s'effectue au moyen du premier interrupteur shunt (F1).

8. Capteur de valeurs de mesure selon l'une au moins des revendications précédentes, caractérisé en ce que par envoi d'un quatrième nombre déterminé d'impulsions, d'une première largeur définie, sur la ligne shunt (Lsh), au moyen du premier interrupteur shunt (S1), le générateur de signaux d'identification (8) peut passer dans un état de fonctionnement d'accès direct, dans lequel des données peuvent être directement mémorisées, par la ligne shunt (Lsh), sur des adresses de zone de mémoire déterminées ou peuvent être extraites d'adresses de zones de mémoire quelconques de la mémoire (18), par l'intermédiaire des lignes de mesure (Lm1, Lm2).

9. Capteur de valeurs de mesure selon la revendication 8, caractérisé en ce que la mise en mémoire/sortie de données dans l'état de fonctionnement d'accès direct s'effectue par envoi sur la ligne shunt (Lsh) d'un signal à trois niveaux, produit au moyen du premier et du deuxième interrupteur shunt (S1, S2), lequel signal convertit le circuit (20) de commande du générateur de signaux d'identification (8), dans des signaux de commande correspondants pour le générateur de signaux d'identification (8), l'introduction en série par bits d'instructions de commande, d'adresses et de données (mémorisation)/instructions de commande et adresses (sortie) s'effectuant au moyen du deuxième interrupteur shunt (S2), et les signaux de commande, d'adresses et de données étant asservis de manière synchrone à un signal de synchronisation produit au moyen du premier interrupteur shunt (S1) (signal à trois niveaux).

10. Capteur de valeurs de mesure selon la revendication 9, caractérisé en ce que la production du signal à trois niveaux s'effectue en ce que des flancs du signal de synchronisation sont décalés dans le temps par rapport aux flancs du signal de commande, d'adresses ou de données.

11. Capteur de valeurs de mesure selon l'une au moins des revendications précédentes, caractérisé en ce que par envoi d'une impulsion d'une seconde largeur définie sur la ligne shunt (Lsh), on met fin, au moyen du premier interrupteur shunt (S1), à la transmission des données d'identification ou à une activation du calibrage shunt.

12. Capteur de valeurs de mesure selon l'une au moins des revendications précédentes, caractérisé en ce que la transmission des données d'identification du générateur de signaux d'identification (8) au circuit d'exploitation, s'effectue dans un format de données asynchrone, le circuit (20) de commande du générateur de signaux d'identification (8) procédant, au moyen du deuxième ou du premier interrupteur shunt auxiliaire (Sh-, Sh+) à la sortie en série par bits des données et, au moyen du premier ou du deuxième interrupteur shunt auxiliaire (Sh+, Sh-), le signal de données étant asservi de manière synchrone à un signal de synchronisation (signal à trois niveaux),

13. Capteur de valeurs de mesure selon la revendication 11, caractérisé en ce que la transmission des données d'identification du capteur d'identification (9) au circuit d'exploitation, par les lignes de mesure (Lm1, Lm2), s'effectue en format de données asynchrone, au moyen d'un signal à trois niveaux, pour la production duquel le signal inversé d'une porte OU (25) recevant les courants de commande, d'adresses ou de données (DO-SDA) et des courants de signaux de synchronisation (CLO-SCL), entre la mémoire (18) et le circuit (20) de commande, commande le premier interrupteur shunt auxiliaire (Sh+) et le signal inversé d'une porte NON-ET (27), recevant ces mêmes courants de signaux, commande l'interrupteur shunt auxiliaire (Sh-).

14. Capteur de valeurs de mesure selon l'une au moins des revendications précédentes 1 à 5 ou 7 à 13, caractérisé en ce que la définition ou la commutation de paramètres de transmission s'effectue au moyen d'un circuit logique câblé fixe ou d'interrupteurs de codage.

15. Capteur de valeurs de mesure selon l'une au moins des revendications précédentes, caractérisé en ce que le capteur de valeurs de mesure peut être commuté au moyen d'un circuit logique (21, 22) câblé fixe ou d'interrupteurs de codage à partir d'un calibrage shunt, au moyen des interrupteurs shunt (S1, S2) et de la résistance shunt (RS) au calibrage shunt, au moyen des interrupteurs shunt auxiliaires (Sh+, Sh-) et des résistances shunt auxiliaires (Rsh+, Rsh-).

16. Capteur de valeurs de mesure selon l'une au moins des revendications précédentes, caractérisé en ce que la première et/ou la deuxième largeur d'impulsion des impulsions à envoyer sur la ligne shunt (Lsh) peut être modifiée au moyen d'un circuit logique câblé fixe ou d'interrupteurs de codage.

17. Capteur de valeurs de mesure selon l'une au moins des revendications précédentes, caractérisé en ce que les données d'identification du capteur comprennent, outre les données de correction pour la compensation des caractéristiques de conversion statiques et/ou dynamiques du capteur de valeurs de mesure (1) et/ou des parties du circuit d'exploitation (13), telles que des défauts d'amplification, des erreurs de point zéro, des défauts de linéarité, etc., des données de fonctionnement supplémentaires pour le capteur de valeurs de mesure (1) ou pour le convertisseur (2, 3) électrophysique, ainsi que des données relatives au lieu d'utilisation du capteur de valeurs de mesure.

18. Capteur de valeurs de mesure selon l'une au moins des revendications précédentes, caractérisé en ce que des composants du générateur de signaux d'identification (8) de faible consommation d'énergie sont connectés directement et des composants (18) de consommation d'énergie supérieure sont connectés par l'intermédiaire d'un circuit d'attente à l'alimentation en énergie (alimentation électrique 19) du convertisseur (2) électrophysique.

19. Capteur de valeurs de mesure selon l'une au moins des revendication précédentes, caractérisé en ce que les interrupteurs commandés électriquement (interrupteurs shunt auxiliaires Sh+, Sh-) sont réalisés par rapport aux éléments (R2, R4 ; R1, R2), pontés ou à ponter, du capteur ou du convertisseur (2, 3) électrophysique, sous la forme d'éléments de commutation de résistance élevée à l'état non commandé et pratiquement de capacité nulle.

20. Capteur de valeurs de mesure selon la revendication 19, caractérisé en ce que les éléments de commutation sont des transistors.

21. Capteur de valeurs de mesure selon la revendication 20, caractérisé en ce que les éléments de commutation sont des transistors à effet de champ.

22. Capteur de valeurs de mesure selon la revendication 20, caractérisé en ce que les éléments de commutation sont des interrupteurs analogiques.

23. Capteur de valeurs de mesure selon l'une au moins des revendications précédentes, caractérisé en ce que la mémoire (18) est un composant de mémoire non volatile effaçable et programmable avec entrée/sortie série.
